# EUROPEAN PATENT APPLICATION

(11) **EP 2 996 161 A1**
(43) Date of publication of application: **16.03.2016**
(21) Application number: 14184648.5
(22) Date of filing: 12.09.2014
(51) Int. Cl.: H01L 31/054

(54) **Micro tracking solar collector**

(71) Applicant: Technische Hochschule Nuernberg Georg-Simon-Ohm, 90489 Nuernberg (DE)
(72) Inventor: Poisel, Hans, 90489 Nürnberg (DE); Lippenberger, Michael, 91099 Poxdorf (DE); Dengler, Philipp, 90489 Nürnberg (DE); Wehnert, Gerd, 91220 Schnaittach (DE); Schlachter, Herbert, 90449 Nürnberg (DE); Dwars, Anja, 90455 Nürnberg (DE); Ziemann, Olaf, 90408 Nürnberg (DE); Helbig, Jens, 90403 Nürnberg (DE)
(74) Representative: Jöstingmeier, Martin

(57) **Abstract**

A solar collector comprises at least one optical component, at least one receiver, and a tracking means. The tracking means preferably is a passive device, which preferably positions the receiver at the center of the optical output of the optical component. Therefore, not the whole solar collector, but only the receiver is adjusted within the solar collector. This allows to build simple, self-contained and self-adjusting solar collectors.

## Description

### Field of the invention

The invention relates to solar collectors or other radiation conducting or receiving devices. It further relates to sun tracking solar collectors.

### Description of the related art

For collecting radiation and specifically for collecting solar radiation, light concentrators may be used. They concentrate the radiation of a large first light entrance surface to a smaller light-sensitive e.g. photovoltaic element, which allows to use this photovoltaic element with a higher efficiency and therefore to build solar collectors at lower costs.

A photovoltaic concentrator is shown in WO 2007/093422 A1. Solar light is collected by a first lens plate having a plurality of lenses which project an image of the sun to a plurality of solar cells. Here, each solar cell is assigned to a lens. This concentrator is inexpensive, but it must be adjusted with respect to the sun, such that the image of the sun always is centered with the center of the solar cell. If the sun moves, the image of the sun will move too, and it may move out of the solar cell. To prevent this, a tracking mechanism is required.

US 8,499,756 B2 discloses a thermal mechanical positioning for radiation tracking. Here, the radiation of the sun which is not used by solar cells is used to heat mechanical components which expand or contract dependent on the amount of radiation they receive. This allows an adjustment along one axis which significantly improves the efficiency of a solar collector. This kind of tracking is not very precise, and therefore requires solar cells or concentrators with a large acceptance angle.

A further sun light concentrator is disclosed in WO 2006/005303. A plurality of mirrors is controlled by electrical micro-actuators to concentrate the light of the sun to a predefined position. The actuators may be controlled by a sensor sensing the position of the sun or by a method calculating the actual position of the sun. A disadvantage is the comparatively high complexity which further requires electronic components needing an electrical power supply.

A lens system for concentrating the light of sun is disclosed in EP 2 204 606 A2. Although such lens systems are designed to have comparatively large acceptance angles, tracking is required.

### Summary of the invention

The problem to be solved by the invention is to provide solar concentrators or solar collectors which have an enlarged acceptance angle of light. Such concentrators or solar collectors may be used without any further tracking devices and would provide a higher output for a longer period of time. They may also be used in conjunction with a very simple tracking mechanism which would provide a rough tracking and wherein the concentrators or solar collectors would provide a precision tracking for increasing efficiency. Furthermore, a higher efficiency of solar collectors should be achieved by improving tracking precision. The tracking devices should be manufactured easily and at low costs.

Solutions of the problem are described in the independent claims. The dependent claims relate to further improvements of the invention.

In a preferred embodiment, a solar collector comprises at least one optical component, at least one receiver, and a tracking means. The tracking means preferably is a passive device, which preferably positions the receiver at the center of the optical output of the optical component. Therefore, not the whole solar collector, but only the receiver is adjusted within the solar collector. This allows to build simple, self-contained and self-adjusting solar collectors.

Generally, the term "optical component" is used herein for any optical element, which is collecting, bundling, focusing, or guiding radiation, preferably light, and most preferably sun light. In a preferred embodiment, the optical component is a lens which most preferably is plano-convex or bi-convex. It may also be a CPC (compound parabolic concentrator), or any other non-imaging optics. The purpose of the optical component is to collect radiation to guide and/or focus it to the receiver. Preferably, the optical component may be a circular lens or a lens with a rectangular shape which may be useful to place a plurality of lenses in a larger rectangular array. The optical component may also comprise a plurality of lenses. A center axis of the optical component may be determined by the geometry of the optical component. In the case of a circular lens, it may be an axis through the center of the lens, while with other lens forms or with other optical systems the center axis would be an axis defined by the center of the light output.

The receiver preferably is a solar cell, but it may be any other suitable component for receiving the radiation energy from the optical component. It also may be a thermal solar collector. The receiver is located at or at least close to a focal point of the optical component or an output point of the optical component, wherein the radiation output of the optical component preferably has approximately the same size as the active surface of the receiver. The receiver is movable preferably in a plane or at least along an axis to track the output of the optical component when the input radiation source, like the sun moves. Preferably, the receiver is located in a plane at a right angle to the center axis to achieve optimum efficiency. Preferably, it is movable within this plane. It is positioned within this plane by a tracking means which moves the receiver such that it is located at the position with maximum radiation density and/or at a position with maximum radiation with respect to the active surface of the receiver.

The tracking means may comprise a material which reacts to the radiation when being exposed to the radiation directly or indirectly. Preferably, the tracking means is arranged sideward to the receiver. It is preferred, if it is approximately in the same plane as the receiver, most preferably it is in the same plane as the receiver. It is further preferred, if the tracking means is connected to this receiver, such that a movement and/or expansion and/or shrinkage of the tracking means moves the receiver in the plane. If the receiver is not at the center of the light beam from the optical component, the tracking means which is arranged sideward to the receiver will receive light and/or radiation. This will lead to a reaction of the tracking means adjusting the position of the receiver.

In an embodiment, the tracking means comprises at least one material which directly reacts by interaction with the radiation, and preferably with the photons. Preferably, the tracking means may comprise liquid crystal polymers which may be doped with photo-isomerizable molecules, like azobenzenes, cinnamic acid, as well as spiro-benzopyran groups resulting in a change of their molecular structure by absorption of photons of suitable wavelength. Preferably, they migrate from a cis- into a trans-configuration, and therefore lead to a shrinking of the radiated area of the tracking means, which would lead to a movement of the receiver.

In another embodiment, the tracking means may comprise a gel with a photo-mechanical response, whereby it is preferred, that the mechanical change of the shape is achieved by transfer of photo-isomerization from a molecular plane to the gel structure.

In a further embodiment, the tracking means comprise materials reacting indirectly to the radiation. For example, these may be heated by radiation and they may change their shape due to thermal effects. In this embodiment, the tracking means may comprise composite materials, where at least one component performs a phase change, for example from a solid phase to a liquid phase, by melting due to increase of temperature. Therefore, the volume of the material may change due to the change of the aggregation state. This change of the aggregation state is reversible, such that when the radiation intensity decreases, the material cools down and the melted component solidifies or freezes. Such materials may be phase-change materials (PCM). Due to a decrease in volume during freezing, the tracking means gets into the original state when the radiation decreases.

In a further preferred embodiment, the material of the tracking means comprises at least one substance for increasing the absorption of radiation. Such substances may comprise carbon nano-materials like carbon nano-tubes or graphenes.

In a preferred embodiment, the tracking means is arranged such that tracking is performed along one axis. In a further embodiment, tracking is performed in a plurality of axes. This may allow compensating further mechanical tolerances, deviations or movements of the solar collector.

The embodiments disclosed herein are preferably suited for applications with high energy levels of radiation, as the energy which is required for operating the tracking means is taken from the radiation. The advantage is, that no further auxiliary energy, like electrical energy, is required for operating the tracking means. As the tracking means may simply be built as a block of a material as described above, or as a star-shaped structure or any other suitable structure of a material as described above, the assembly can be very compact. This allows to build the solar collectors or concentrators as a small and compact module, whereby a large number of such modules may be arranged together as a larger array.

A preferred field of use of these embodiments is in solar concentrators. Modern multi-junction receivers have a high efficiency of about 40 % and may use the whole spectrum of solar radiation. As these multi-junction detectors are expensive, they should be used with high radiation intensity. Therefore, a concentrator is required. Modern concentrators have a concentration factor of about 1000. Generally, the higher the concentration factor is, the smaller is the receiving angle of the concentrator. Therefore, a comparatively precise alignment of the receiver is required. In large assemblies having a high number of receivers, mechanical tolerances can sum up, such that not every receiver is precisely aligned with respect to its optical component to the sun. Here, devices with tracking means as described in the embodiments allow adjustment of each individual receiver to obtain its optimum performance and efficiency.

### Description of Drawings

In the following the invention will be described by way of example, without limitation of the general inventive concept, on examples of embodiment with reference to the drawings.
- Figure 1: shows a preferred embodiment of a micro-tracking solar collector in a sectional view.
- Figure 2: shows a solar collector in a top view.
- Figure 3: shows a further embodiment of the tracking means in a top view.
- Figure 4: shows a light ray diagram with centered sun.
- Figure 5: shows a light ray diagram with the sun having an offset to the center axis.
- Figure 6: shows a light ray diagram with the sun having an offset to the center axis, with adjusted receiver.
- Figure 7: shows an embodiment in a perspective view.
- Figure 8: shows an embodiment with a misaligned sun in a perspective view.

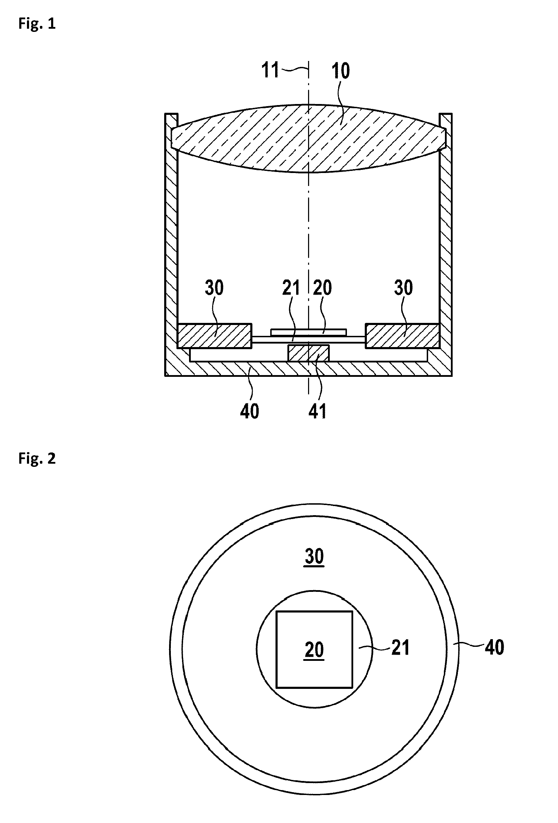

In Figure 1, a preferred embodiment of a micro-tracking solar collector is shown in a sectional view. Preferably, a housing 40 is provided, holding all the components in a close spatial relationship and protecting the components from environmental influences. This results in a simple and robust unit. The housing 40 preferably holds an optical component 10, which is a bi-convex lens in this embodiment, but which can be any other component as described above. This optical component has a center axis 11 which defines the center of the radiation output if a light source is arranged distant from the solar collector aligned with the center axis. A receiver 20 is preferably centered to the center axis 11 and in this embodiment distant from the optical component 10 within the housing 40. It is preferably held by a receiver base 21, which is further attached to and preferably held by at least one tracking means 30. The receiver 20 may also be attached to the tracking means 30 without a receiver base. The receiver base may be printed circuit board for connecting the receiver. There may further be a base support 41 for holding the receiver or receiver base in a predetermined plane, resulting in a predetermined distance to the optical component. Electrical cables for connecting the receiver may be provided are not shown herein.

In Figure 2, a solar collector is shown in a top view. The receiver 20 is preferably arranged at the center and is held by receiver base 21. The receiver base 21 is surrounded by tracking means 30.

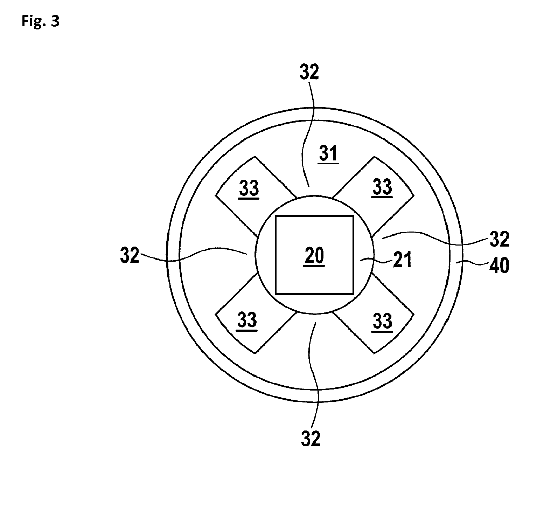

In Figure 3, a further embodiment of the tracking means is shown in a top view. Here, the tracking means 31 has a plurality of sections 32 with gaps 33 in-between. This embodiment shows a tracking means with four segments, although the number of segments may be different. There may be any number of segments.

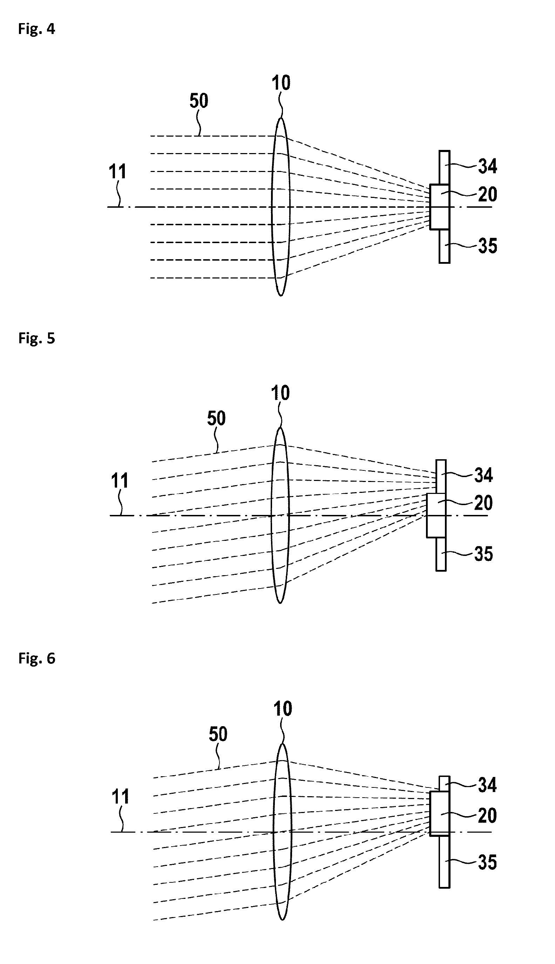

In Figure 4, a light ray diagram is shown, wherein the sun is centered to center axis 11. Herein, the tracking means is split into a first section 34 and second section 35. These sections may be part of the same tracking means 30 or they may be different segments of a segmented tracking means 31. Here, all light rays 50 are deflected by the optical component to the receiver 20, which works with optimum efficiency.

In Figure 5, a light ray diagram with the sun having an offset to the center axis is shown. Here, the solar collector is not aligned to the sun, resulting in the light rays coming under an angle to the optical component and being deflected to a position different to the position of the receiver 20. Therefore, only a part of the light can be used by the receiver. Another part of the light falls on the first tracking means section 34, and leads to a reaction of this tracking means section, as will be shown in the next Figure.

In Figure 6, a light ray diagram with the sun having an offset to the center axis, with adjusted receiver. In this Figure, the tracking means has reacted to the radiation and the first section 34 of the tracking means shrunk, while the second section of the tracking means has expanded such that the receiver has moved to a new position, receiving more of the radiation. To keep this state stable, it is necessary, that the tracking means remain in this (shrunk) state. This requires that still some radiation is absorbed by the first section of the tracking means. As a consequence, the tracking means cannot fully compensate the deviation of the light beams. Dependent on the characteristics of the materials of the tracking means, only a very low amount of solar energy is required for adjusting the tracking means which results in a very good compensation, as most of the light is available for the receiver, and only a small amount is consumed by the tracking means.

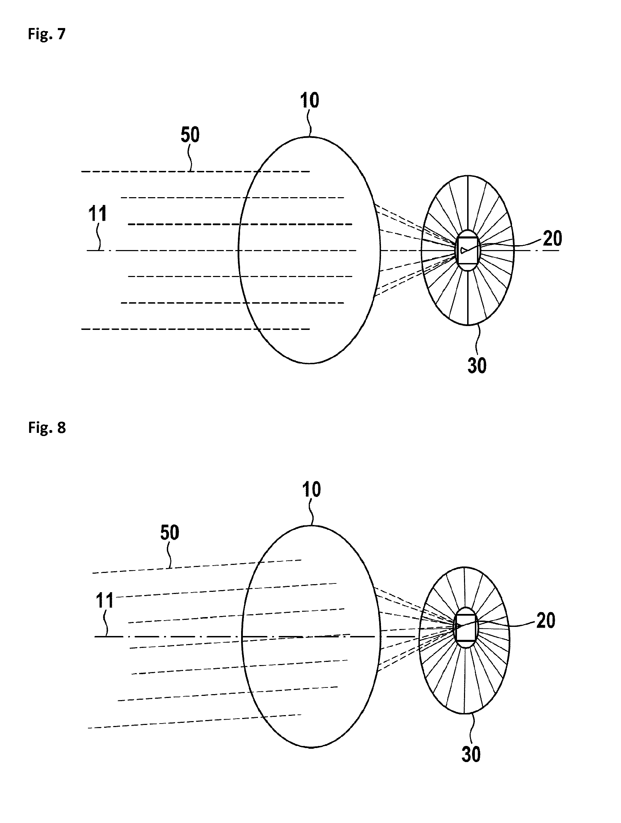

In Figure 7, an embodiment is shown in a perspective view. Here, the collector is aligned with the sun, which results in the sun rays 50 propagating parallel to the center axis 11. The whole radiation is focused to the receiver 20. In this embodiment, the tracking means 30 may either be a plate as previously shown, or it may comprise spokes.

In Figure 8, the previous embodiment is shown when misaligned to the sun. Here again, light enters the optical component under an angle offset to center axis 11. Due to reaction of the tracking means 30, the receiver 20 is positioned at the new focus point of the optical component, which corresponds to Figure 6.

### List of reference numerals

- 10: optical component
- 11: center axis
- 20: receiver
- 21: receiver base
- 30: tracking means
- 31: alternate tracking means
- 32: sections of tracking means
- 33: gaps between sections of tracking means
- 34: first tracking means section
- 35: second tracking means section
- 40: housing
- 41: base support
- 50: light rays

## Claims

1. Solar collector, comprising an optical component (10) and a receiver (20) which is adjustable in its position by at least one tracking means (30) for moving or adjusting the receiver in relationship to the optical component, the tracking means comprising a material which shrinks and/or expands upon reception of radiation through the optical component (10).

2. Solar collector according to claim 1,
**characterized in that**
the optical component (10) has a center axis (11), and
the receiver (20) is arranged distant from the optical component and movable in a plane under a right angle to the center axis (11) by at least one of the tracking means (30) arranged in approximately the same plane.

3. Solar collector according to any of the previous claims,
**characterized in that**
the optical component is a lens.

4. Solar collector according to claim 3,
**characterized in that**
the lens is a piano-convex or a bi-convex lens.

5. Solar collector according to claim 1 or 2,
**characterized in that**
the optical component (10) is a CPC (compound parabolic concentrator).

6. Solar collector according to any of the previous claims,
**characterized in that**
the tracking means (30) comprises at least one material which directly reacts by interaction with the radiation.

7. Solar collector according to claim 6,
**characterized in that**
the tracking means (30) comprises liquid crystal polymers which may be doped with photo-isomerizable molecules, like azobenzenes, cinnamic acid, as well as spiro-benzopyran groups.

8. Solar collector according to claim 6,
**characterized in that**
the tracking means (30) comprises at least one gel with a photo-mechanical response.

9. Solar collector according to any of claims 1 to 5,
**characterized in that**
the tracking means (30) comprises at least one material reacting indirectly to the radiation.

10. Solar collector according to claim 9,
**characterized in that**
the tracking means (30) comprises at least one material changing the change the shape due to thermal effects.

11. Solar collector according to claim 9,
**characterized in that**
the tracking means (30) comprises at least one composite material, having a plurality of different materials, where at least one component performs a phase change, for example from a solid phase to a liquid phase, by melting due to increase of temperature.

12. Solar collector according to claim 11,
**characterized in that**
the composite material comprise at least on phase-change material (PCM).

13. Solar collector according to any of the previous claims,
**characterized in that**
the tracking means (30) comprises at least one substance for increasing the absorption of radiation.

14. Solar collector according to claim 13,
**characterized in that**
the tracking means (30) comprises carbon nanomaterials like carbon nano-tubes or a graphene.

15. Method for adjusting a receiver (20) in a solar collector, comprising an optical component (10) by moving the receiver by means of a tracking means comprising a material which shrinks and/or expands upon reception of radiation through the optical component (10).
